# EUROPEAN PATENT APPLICATION

(11) **EP 3 190 694 A1**
(43) Date of publication of application: **12.07.2017**
(21) Application number: 15839050.0
(22) Date of filing: 26.08.2015
(51) Int. Cl.: H02M 7/48, H01L 25/07, H01L 25/18

(54) **POWER MODULE**

(30) Priority: 05.09.2014 JP 2014180905
(71) Applicant: TOYOTA JIDOSHA KABUSHIKI KAISHA, Toyota-shi, Aichi-ken 471-8571 (JP)
(72) Inventor: KIMURA Takashi, Toyota-shi Aichi 471-8571 (JP); IDE Yuki, Toyota-shi Aichi 471-8571 (JP); NAKAJIMA Kiyofumi, Toyota-shi Aichi 471-8571 (JP); KAWASHIMA Takanori, Toyota-shi Aichi 471-8571 (JP); TSUCHIMOCHI Shingo, Toyota-shi Aichi 471-8571 (JP)
(74) Representative: D Young & Co LLP
(86) International application number: PCT/JP2015/074106
(87) International publication number: WO 2016/035651

(57) **Abstract**

A power module (10) according to the present invention includes an inverter circuit (20) and a pair of conductors (31, 32) that sandwich the inverter circuit. The inverter circuit includes a positive bus bar (21), a negative bus bar (22), a plurality of output bus bars (23u, 23v, 23w), and a plurality of element pairs (24, 25, 26). The element pair has such a configuration that a semiconductor element coupled to the positive bus bar and a semiconductor element coupled to the negative bus bar are coupled to each other via the output bus bar. The semiconductor elements each include a switching element and a diode connected in antiparallel with the switching element. The positive bus bar, the element pair, and the negative bus bar define a conductive path exhibiting a loop-like shape facing the conductors inside the above-mentioned region.

## Description

### Technical Field

The present invention relates to a power module including an inverter circuit and a pair of conductors that sandwich the inverter circuit.

### Background Art

Hitherto, a power module including an inverter circuit that includes a plurality of semiconductor elements (for example, elements including power semiconductors, e.g., IGBTs) is proposed as a power module for supplying electric power to, for example, a driving electric motor mounted on a hybrid vehicle.

The inverter circuit is an electronic circuit configured to convert input DC power into AC power, thereby outputting the AC power. Specifically, the inverter circuit includes, as an example, a semiconductor element (upper arm) coupled to an input bus bar on a high voltage side, a semiconductor element (lower arm) coupled to an input bus bar on a low voltage side, and an output bus bar (midpoint terminal) that branches to extend from a conductive path for coupling those elements to each other. In general, the semiconductor element includes a switching element and a diode connected in antiparallel with the switching element. The inverter circuit is configured to achieve the above-mentioned power conversion by switching each switching element at a specific timing (for example, based on PWM control).

An inverter circuit included in one of related-art power modules (hereinafter referred to as "related-art module") is structured such that a plurality of semiconductor elements (IGBTs) are arranged in an array on the same plane with each of terminals (collector terminal of the upper arm and emitter terminal of the lower arm) of the adjacent semiconductor elements being directly connected to each other without the intermediation of a bus bar. With this structure, the related-art module can form the inverter circuit without the use of a bus bar, which allows the module to be reduced in size (for example, so-called, projected area of PCU) (see, for example, PTL 1).

In the following, for the sake of convenience, the input bus bar on the high voltage side is referred to as "positive bus bar", the input bus bar on the low voltage side is referred to as "negative bus bar", and a combination of the semiconductor element (upper arm) coupled to the positive bus bar and the semiconductor element (lower arm) coupled to the negative bus bar is referred to as "element pair".

### Citation List

### Patent Literature

[PTL 1] JP 2012-190833 A

### Summary of Invention

In general, an electronic circuit has parasitic inductance (floating inductance) ascribable to various electronic parts included in the circuit and the structure of the circuit itself and other such factors. The parasitic inductance causes a surge voltage involved in a change of current (induced electromotive force that occurs in such a direction as to inhibit a change of current) in a circuit, and is therefore a cause of an energy loss in the circuit. In particular, in an inverter circuit included in a power module, a large surge voltage may occur in the circuit at a time of switching of a semiconductor element in association with an increase or decrease in recovery current ascribable to a recovery process (reverse recovery process) of a diode within the semiconductor element (described later in detail).

Meanwhile, from the viewpoint of enhancing energy efficiency of an entire system to which the power module is applied (for example, fuel efficiency of a hybrid vehicle), it is desired that an operating frequency of the inverter circuit be high. However, in general, as the operating frequency of the inverter circuit becomes higher, a time variation rate of the recovery current at the time of the switching of the semiconductor element becomes higher, which increases the surge voltage that occurs in the circuit. That is, the parasitic inductance of the inverter circuit may be a cause of inhibiting the speed-up of the power module. Hence, it is desired that the parasitic inductance of the inverter circuit (that is, entire power module) be reduced as much as possible.

In the related-art module, the terminals extending from the respective semiconductor elements are directly connected to each other without particular consideration of the parasitic inductance of the inverter circuit. It is therefore considered that the parasitic inductance of the related-art module is not always reduced even when the related-art module is reduced in size by eliminating bus bars.

In view of the above-mentioned problems, the present invention has an object to provide a power module having a configuration capable of reducing parasitic inductance.

In order to solve the above-mentioned problems, according to one embodiment of the present invention, there is provided a power module, including:
an inverter circuit; and
a "pair of conductors" that sandwich the inverter circuit.

The inverter circuit includes:
"a positive bus bar, a negative bus bar, and a plurality of output bus bars" that extend from an outside of a region sandwiched between the pair of conductors to an inside of the region; and
a "plurality of element pairs" provided inside the region,
   the plurality of element pairs each having such a configuration that a semiconductor element coupled to the positive bus bar and a semiconductor element coupled to the negative bus bar are coupled to each other via each of the plurality of output bus bars,
   the semiconductor elements each including a switching element and a diode connected in antiparallel with the switching element.

In addition, in the inverter circuit, "the positive bus bar, the plurality of element pairs, and the negative bus bar" define "conductive paths" each exhibiting a loop-like shape facing the pair of conductors inside the region.

According to the above-mentioned configuration, when a current (recovery current) is caused to flow so as to pass through the "conductive path" exhibiting the "loop-like shape", an eddy current flowing in a reverse direction to the recovery current occurs in both the "pair of conductors" facing the conductive path. Then, a magnetic flux that occurs due to those eddy currents cancels a magnetic flux that occurs due to the current that passes through the conductive path. That is, a change of the magnetic flux on a periphery of the conductive path is suppressed. In addition, the "conductive paths" exist in association with the respective "plurality of element pairs" (that is, the same number as the number of element pairs), and a phenomenon in which the change of magnetic flux is suppressed occurs in all of those plurality of "conductive paths" (that is, in the entire inverter circuit). As a result, apparent parasitic inductance of the inverter circuit is reduced, and when the entire power module is assumed to be one system, the parasitic inductance of the system is reduced.

Now, the parasitic-inductance reduction effect described above is described in more detail.

The power module is configured to operate the inverter circuit after input terminals (positive bus bar and negative bus bar) is connected to an external power source and an output terminal (output bus bar) is connected to an external load, e.g., an electric motor. During this operation, a phase difference sometimes occurs between a voltage at the output terminal (output bus bar) and a voltage at the external load due to an inductance component included in the external load or the like. In this case, a direction of a current passing through the output terminal (output bus bar) is determined based on a potential difference ascribable to the phase difference (the current is caused to flow from a high potential side to a low potential side). Therefore, a switching state of the element pair (which of the two semiconductor elements is in an on state and which is in an off state) and the direction of the current passing through the output terminal (output bus bar) in actuality (direction of flowing into the inverter circuit or direction of flowing out of the inverter circuit) do not always correspond to each other on a one-to-one basis.

For example, in a case where the "semiconductor element coupled to the positive bus bar" is in an on state (the upper arm is in a conducting state) and the "semiconductor element coupled to the negative bus bar" is in an off state (the lower arm is in an interrupted state), when a current is caused to "flow into" the output bus bar, the current passes through a "diode" within the semiconductor element coupled to the positive bus bar (upper arm) to travel to a power source. At this time, a forward bias is applied to the diode, and hence a depletion layer of the diode is reduced. After that, when the switching state of the element pair is switched over (when the upper arm is turned off and the lower arm is turned on), a reverse bias is applied to the above-mentioned diode. The diode has property for interrupting a current at a time of application of the reverse bias, but a current in a reverse bias direction passes through the diode only during a period (reverse recovery process) required until the depletion layer reduced at the time of the application of the forward bias is sufficiently enlarged again. This current is generally referred to as "recovery current", and is caused to flow so that the "conductive paths" defined by "the positive bus bar, the element pairs, and the negative bus bar" are short-circuited.

The conductive path exhibits the "loop-like shape facing the pair of conductors" "inside" the "region sandwiched between the pair of conductors". Therefore, when the recovery current is caused to flow through the conductive path, the eddy current flowing in a "reverse direction" to the recovery current occurs in both the conductors due to an electromagnetic induction effect. Those eddy currents occur along the conductive path, and exhibit shapes corresponding to the shape (loop-like shape) of the conductive path. In addition, a direction of a magnetic flux created by each of those eddy currents is a "reverse direction" to a direction of a magnetic flux created by the recovery current. Therefore, a magnetic flux ascribable to the recovery current is canceled by a magnetic flux ascribable to those eddy currents. In addition, those eddy currents occur on both sides of the conductive path so as to sandwich the conductive path, and hence the magnetic flux ascribable to the recovery current is canceled more positively than in a case where the eddy current occurs only on one side of the conductive path.

Therefore, even when the recovery current is caused to flow through the "conductive path", the magnetic flux ascribable to the recovery current is canceled by the eddy current, and hence a change in the number of magnetic fluxes interlinked with the conductive path is suppressed. As a result, a surge voltage that occurs in the "conductive path" is reduced to a lower level than in a case where this suppression phenomenon does not occur. In other words, the apparent parasitic inductance in the "conductive path" is reduced by a reduced amount of the surge voltage.

In the power module according to the present invention, the above-mentioned "conductive path" through which a short-circuit current can be caused to flow exists for each "element pair" in association with each of the "plurality of element pairs". Further, as described above, the apparent parasitic inductance is reduced in each of those plurality of conductive paths (that is, in the entire inverter circuit). In other words, when the "entire power module including the inverter circuit and the pair of conductors" is assumed to be one system, the parasitic inductance of the system is reduced.

Accordingly, the power module according to the present invention has a configuration capable of reducing parasitic inductance.

Incidentally, the above-mentioned "diode connected in antiparallel with the switching element" represents a so-called free wheeling diode, and may be provided in the semiconductor element as an element different from the switching element (e.g., IGBT), or may be a parasitic diode structurally built into the switching element (e.g., MOSEFT).

The "positive bus bar" and the "negative bus bar" described above represent a bus bar connected to a terminal of the external power source on a high potential side and a bus bar connected to a terminal of the external power source on a low potential side, respectively. For example, when an IGBT is used as the switching element, the former represents a collector bus bar, and the latter represents an emitter bus bar. Further, for example, when a MOSEFT is used as the switching element, the former represents a drain bus bar, and the latter represents a source bus bar.

The above-mentioned "facing" represents that a positional relationship between the conductive path and the pair of conductors is such a relationship that "an induced current can occur in both the pair of conductors due to the current passing through the conductive path". The above-mentioned "loop-like shape" represents that the shape of the conductive path is such a shape that "the induced current thus occurring in the conductor can form a spiral shape (that is, can form an eddy current)".

Specific examples of the "loop-like shape" include: a shape of the conductive path exhibited when "the conductive path is curved around the inside of the above-mentioned region along side surfaces of the above-mentioned region substantially by one round"; and a shape of the conductive path exhibited when "the positive bus bar and the negative bus bar are spaced apart from each other across the element pair inside the above-mentioned region, and in a boundary plane between the inside and the outside of the above-mentioned region, the positive bus bar and the negative bus bar are in as close proximity to each other as a minimum distance that enables insulation".

Specific examples of the "facing" include a state in which, assuming that the conductive path exists on a virtual plane, "the virtual plane in which the conductive path exists and a surface of each of the pair of conductors are not perpendicular to each other". The virtual plane and the surface of the conductor are not necessarily parallel with each other, but it is desired that the virtual plane and the surface of the conductor be nearly parallel with each other from the viewpoint of reducing the parasitic inductance of the power module more efficiently.

Next, a description is made of control devices according to a plurality of aspects (first to third aspects) of the present invention.

### ▪First Aspect

In general, a magnitude of the parasitic inductance of an electronic circuit depends on a length of the electronic circuit. Therefore, it is considered that, when the plurality of "conductive paths" have mutually different lengths, the magnitudes of the parasitic inductance of the respective conductive paths differ from one another. That is, the respective "conductive paths" are considered to have different magnitudes of parasitic inductance. It is desired that such a difference in parasitic inductance (hereinafter referred to as "variations in parasitic inductance") be as small as possible.

Therefore, the power module according to this aspect may be configured such that:
the pair of conductors have flat plate-like shapes parallel with each other; and
the conductive paths exist on the same virtual plane that is parallel with the pair of conductors.

According to the above-mentioned configuration, each of the distances between the respective conductive paths and the conductors has a fixed value independently of the conductive path. In this case, as the conductive path becomes longer, the eddy current occurring in the conductor along the conductive path also becomes longer, and the parasitic-inductance reduction effect corresponding to the length of the conductive path can be obtained. Therefore, the power module according to this aspect can reduce the variations in parasitic inductance.

Incidentally, to be strict, the conductive path exhibits a three-dimensional shape corresponding to a three-dimensional arrangement of the respective elements (element pair, positive bus bar, and negative bus bar) that form the path, and does not necessarily exist on a specific "virtual plane". However, in general, the inverter circuit of the power module is so small (thin) that the three-dimensional arrangement (difference in arrangement in the thickness direction) of the respective elements is negligible from the viewpoint of defining the positional relationship between the conductive path and the conductor as in this aspect. Therefore, the conductive path can be assumed to exist on the "virtual plane".

### ▪Second Aspect

In order to cause eddy currents to occur in the pair of conductors as positively as possible, it is desired that the "loop-like shape" of the conductive path be as close to a closed path as possible.

Therefore, the power module according to this aspect may be configured such that the positive bus bar and the negative bus bar are spaced apart from each other by a minimum distance that enables insulation in a boundary plane between the outside and the inside of the region.

According to the above-mentioned configuration, a distance between both ends of the conductive path (distance between the positive bus bar and the negative bus bar in the above-mentioned boundary plane) is as short as the minimum distance that enables insulation, and hence the shape of the conductive path inside the above-mentioned region can be formed to be closer to the closed path. Therefore, the power module according to this aspect can cause eddy currents to occur in the pair of conductors more positively.

### ▪Third Aspect

Incidentally, the power module according to the present invention only needs to have a configuration capable of achieving the parasitic-inductance reduction effect, and no particular limitations are imposed on a specific arrangement of the respective elements (pair of conductors, respective semiconductor elements, positive bus bar, negative bus bar, and output bus bar) and the like. For example, the arrangement of the respective elements of the power module according to the present invention may be determined in consideration of not only reduction in parasitic inductance but also reduction in size of the power module, improvement in heat dissipation performance, and the like.

Specifically, the power module according to this aspect may be configured such that:
the pair of conductors include first metal plate and a second metal plate that are configured to release heat emitted by the plurality of element pairs toward the outside of the region;
the output bus bar includes a first end portion coupled to the semiconductor element coupled to the positive bus bar and a second end portion coupled to the semiconductor element coupled to the negative bus bar; and
inside the region:
   the positive bus bar and the first metal plate are adjacent to each other while being insulated from each other;
   the negative bus bar and the second metal plate are adjacent to each other while being insulated from each other;
   the first end portion and the second metal plate are adjacent to each other while being insulated from each other;
   the second end portion and the first metal plate are adjacent to each other while being insulated from each other;
   the semiconductor element coupled to the positive bus bar is sandwiched between the positive bus bar and the first end portion; and
   the semiconductor element coupled to the negative bus bar is sandwiched between the negative bus bar and the second end portion.

According to the above-mentioned configuration, the "conductive path" defined by the positive bus bar, the semiconductor element coupled to the positive bus bar, the semiconductor element coupled to the negative bus bar, and the negative bus bar" is formed at a position adjacent to both the first metal plate and the second metal plate. Further, it can be assumed that the virtual plane (see the first aspect described above) in which the conductive path exists and each of the metal plates are parallel with each other when the respective bus bars, the respective semiconductor elements, insulating layers for insulation, and the like have sufficiently small thicknesses. Therefore, the power module according to this aspect can efficiently reduce the parasitic inductance of the above-mentioned module.

Further, the pair of conductors (metal plates) have a heat dissipation function, and hence the power module can be reduced in size to a lower level than in a case of providing a heat dissipation plate separately from those conductors. In addition, heat emitted by the semiconductor element coupled to the positive bus bar is released from the two metal plates via the positive bus bar and the output bus bar, while heat emitted by the semiconductor element coupled to the negative bus bar is also released from the two metal plates (from both sides of the semiconductor element) via the negative bus bar and the output bus bar. Therefore, the heat emitted by the respective semiconductor elements can be released evenly through the use of both the two metal plates, and hence the heat dissipation function of the metal plates can be used to the maximum, which can increase heat dissipation performance of the power module.

Accordingly, the power module according to this aspect can simultaneously achieve not only the reduction in parasitic inductance but also the reduction in size of the power module and the improvement in heat dissipation performance.

### Brief Description of Drawings

FIG. 1 is a schematic diagram for illustrating a schematic configuration of a power module according to an embodiment of the present invention.
FIG. 2 is a schematic sectional diagram obtained when the power module illustrated in FIG. 1 is cut along a plane including the axis A-A.
FIG. 3 is a schematic diagram obtained when the power module illustrated in FIG. 1 is viewed from above.
FIGS. 4 are schematic diagrams for illustrating an example of conductive paths within the power module illustrated in FIG. 1.
FIGS. 5 are schematic diagrams for illustrating an example of the conductive paths within the power module illustrated in FIG. 1.
FIGS. 6 are schematic diagrams for illustrating an example of the conductive paths within the power module illustrated in FIG. 1.
FIGS. 7 are schematic diagrams for illustrating an example of the conductive paths within the power module illustrated in FIG. 1.
FIG. 8 is a schematic diagram for illustrating a power module according to another aspect of the present invention.
FIG. 9 is a schematic diagram for illustrating a power module according to another aspect of the present invention.

### Description of Embodiments

### <Embodiment>

### [Outline of Apparatus]

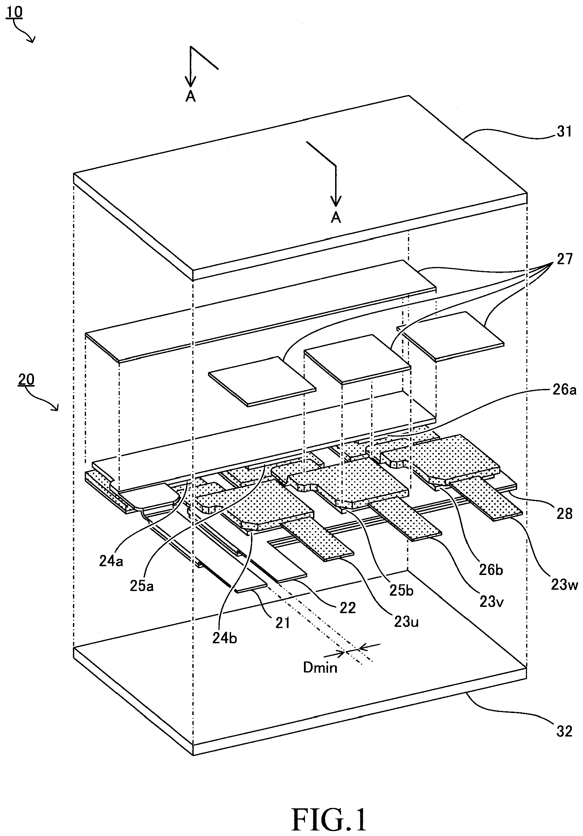

FIG. 1 is an illustration of a schematic configuration of a power module according to an embodiment of the present invention (hereinafter referred to as "embodiment module 10"). The embodiment module 10 is a 6-in-1 module obtained by providing six semiconductor elements in one module, and has a shape of a substantially rectangular parallelepiped.

Specifically, the embodiment module 10 includes an inverter circuit 20 and a pair of metal plates 31 and 32 that sandwich the inverter circuit 20. As illustrated in FIG. 1, the inverter circuit 20 is arranged inside a region sandwiched between the metal plates 31 and 32. In an actual case, the inverter circuit 20 and the metal plates 31 and 32 are integrated by resin or the like (resin sealing) in a state of being in close contact with each other across an insulating layer. However, in FIG. 1, for an easy understanding of the configuration of the embodiment module 10, the inverter circuit 20 and the metal plates 31 and 32 are illustrated in positions spaced apart from each other.

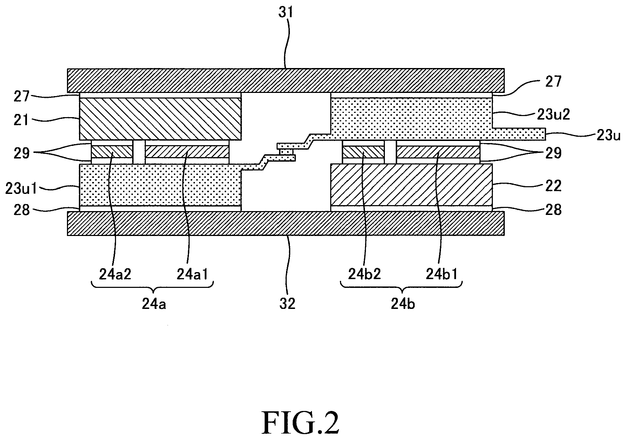

The inverter circuit 20 includes a collector bus bar (positive bus bar) 21, an emitter bus bar (negative bus bar) 22, three output bus bars (23u, 23v, and 23w), six semiconductor elements (24a, 24b, 25a, 25b, 26a, and 26b), and insulating layers 27 and 28. In the inverter circuit 20, the semiconductor elements 24a and 24b are coupled to each other via the output bus bar 23u to form a first element pair (see a description regarding FIG. 2 described later). In the same manner, the semiconductor elements 25a and 25b are coupled to each other via the output bus bar 23v to form a second element pair, and the semiconductor elements 26a and 26b are coupled to each other via the output bus bar 23w to form a third element pair.

The collector bus bar 21, the emitter bus bar 22, and the output bus bars 23u, 23v, and 23w extend from the outside toward the inside of the region sandwiched between the metal plates 31 and 32. The collector bus bar 21 and the emitter bus bar 22 are adjacent to each other so as to be spaced apart from each other by a minimum distance Dmin that enables insulation in a boundary plane between the inside and the outside of the above-mentioned region. Meanwhile, the output bus bars 23u, 23v, and 23w pass through the same boundary plane as the above-mentioned boundary plane through which the collector bus bar 21 and the emitter bus bar 22 pass. When the embodiment module 10 is put to practical use, the collector bus bar 21 and the emitter bus bar 22 are connected to a terminal on a high voltage side and a terminal on a low voltage side of an external power source (DC power source), respectively, and the output bus bars 23u, 23v, and 23w are connected to respective terminals of an external load (in this example, electric motor configured to operate with a three-phase alternating current or the like).

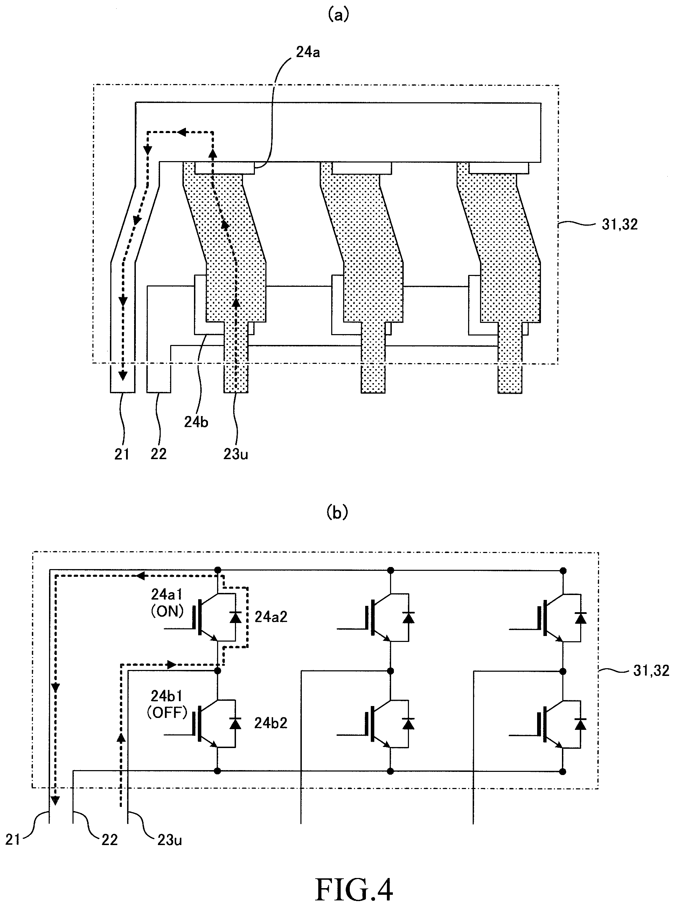

More specifically, as illustrated in FIG. 2 (sectional diagram obtained when the output bus bar 23u and the element pair 24a and 24b of FIG. 1 are cut along the line A-A), the semiconductor element 24a coupled to the collector bus bar 21 includes an IGBT 24a1 and a diode 24a2. The diode 24a2 is connected in antiparallel with the IGBT 24a1 (see FIG. 4(b)). The semiconductor element 24b coupled to the emitter bus bar 22 includes an IGBT 24b1 and a diode 24b2 connected in antiparallel with the IGBT 24b1. The semiconductor element 24a and the semiconductor element 24b are coupled to each other via the output bus bar 23u. In the same manner, the other semiconductor elements 25a, 25b, 26a, and 26b, which are not illustrated in this sectional diagram, include IGBTs and diodes and are each connected to the corresponding semiconductor element via the output bus bar.

The semiconductor element 24a is connected to the collector bus bar 21 via solder 29, and connected to one end (first end portion) 23u1 of the output bus bar 23u via the solder 29. That is, the semiconductor element 24a is sandwiched between the collector bus bar 21 and the one end 23u1 of the output bus bar. Meanwhile, the semiconductor element 24b is connected to the emitter bus bar 22 via the solder 29, and connected to another end (second end portion) 23u2 of the output bus bar 23u via the solder 29. That is, the semiconductor element 24b is sandwiched between the emitter bus bar 22 and the another end 23u2 of the output bus bar.

The collector bus bar 21 and the metal plate 31 are adjacent to each other via the insulating layer 27. Meanwhile, the emitter bus bar 22 and the metal plate 32 are adjacent to each other via the insulating layer 28. The one end 23u1 of the output bus bar and the metal plate 32 are adjacent to each other via the insulating layer 28. Meanwhile, the another end 23u2 of the output bus bar 23u and the metal plate 31 are adjacent to each other via the insulating layer 27.

The metal plates 31 and 32 each have a thin plate-like shape that is a rectangle in plan view. The metal plates 31 and 32 have the same shape, and are arranged in parallel with each other. The metal plate 31 is configured to receive heat emitted by the element pair 24a and 24b via the collector bus bar 21 and the another end 23u2 of the output bus bar, and to release the heat toward the outside of (in the figure, toward above) the embodiment module 10. Meanwhile, the metal plate 32 is configured to receive heat emitted by the semiconductor elements 24a and 24b via the emitter bus bar 22 and the one end 23u1 of the output bus bar, and to release the heat toward the outside of (in the figure, toward below) the embodiment module 10. In the same manner, the metal plates 31 and 32 are further configured to release heat emitted by the other semiconductor elements 25a, 25b, 26a, and 26b toward the outside of the embodiment module 10. That is, the metal plates 31 and 32 have a function of releasing heat emitted from the inverter circuit 20 to cool the inverter circuit 20.

In FIG. 2, for the sake of convenience in description, the thickness and size of each of the elements are described as being different from the thickness and size of each of the actual elements. For example, the thickness of each of the elements is sufficiently small in actuality compared to the area of the metal plates 31 and 32. Hence, in an actual case, the embodiment module 10 has a thin plate-like shape having a smaller length in a thickness direction than a length in a longitudinal direction or in a lateral direction.

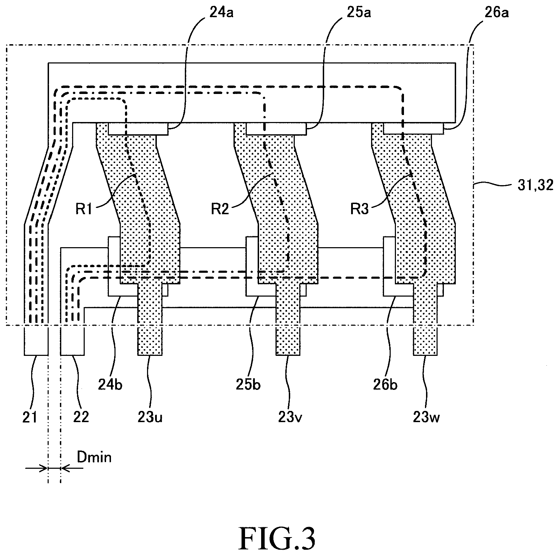

As illustrated in FIG. 3 (schematic diagram obtained when the embodiment module 10 is viewed from above), a path R1 (conductive path through which a recovery current described later passes) defined by the collector bus bar 21, the semiconductor element 24a, the semiconductor element 24b, and the emitter bus bar 22 exhibits a loop-like shape inside the region sandwiched between the metal plates 31 and 32. Specifically, the collector bus bar 21 and the emitter bus bar 22 are spaced apart from each other across the element pair 24a and 24b inside the above-mentioned region, and the collector bus bar 21 and the emitter bus bar 22 are in as close proximity to each other as the minimum distance Dmin that enables insulation in the boundary plane between the inside and the outside of the above-mentioned region.

In the same manner, a path R2 defined by the collector bus bar 21, the semiconductor element 25a, the semiconductor element 25b, and the emitter bus bar 22 also exhibits a loop-like shape inside the above-mentioned region. In the same manner, a path R3 defined by the collector bus bar 21, the semiconductor element 26a, the semiconductor element 26b, and the emitter bus bar 22 also exhibits a loop-like shape inside the above-mentioned region.

To be strict, those loop-like paths R1, R2, and R3 each exhibit a three-dimensional shape slanted toward the thickness direction of the inverter circuit 20 (see FIG. 2). However, as described above, the thickness of each of the elements of the inverter circuit 20 is sufficiently small compared to the area of the metal plates 31 and 32. Hence, the paths R1, R2, and R3 can be assumed to exist on the same virtual plane that is substantially parallel with both the metal plates 31 and 32. In other words, those paths R1, R2, and R3 each exhibit a shape facing the metal plates 31 and 32.

### [Reduction in Parasitic Inductance]

With reference to FIGS. 4 to FIGS. 7, a description is made of the parasitic inductance of the embodiment module 10. The inverter circuit 20 of the embodiment module 10 is configured to switch the six semiconductor elements 24a to 26b based on timings of on and off determined based on PWM control by a control device (not shown). Each output bus bar is coupled to the external load (electric motor), and hence at the time of the switching, the direction of a current passing through each output bus bar is determined based on a potential difference between each output bus bar and the external load (which is ascribable to a phase difference between each output bus bar and external load).

For example, in a case where the IGBT 24a1 of the semiconductor element 24a is in an on state (conducting state) and the IGBT 24b1 of the semiconductor element 24b is in an off state (interrupted state), a current is caused to flow into the output bus bar 23u when a potential of the output bus bar 23u is lower than a potential of the external load. At this time, as illustrated in a schematic diagram of FIG. 4(a) and a circuit diagram of FIG. 4(b), the current passes through the diode 24a2 to travel to the power source (collector bus bar 21). When the current is thus caused to flow, a forward bias is applied to the diode 24a2, and a depletion layer of the diode 24a2 is reduced.

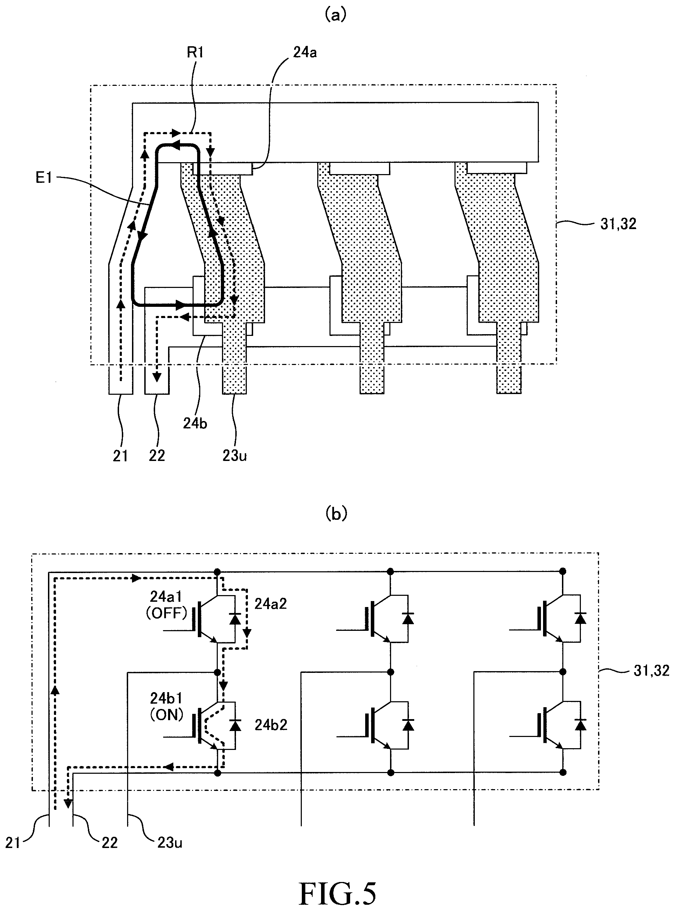

After that, as illustrated in a schematic diagram of FIG. 5(a) and a circuit diagram of FIG. 5(b), when the IGBT 24a1 is turned off and the IGBT 24b1 is turned on, a reverse bias is applied to the diode 24a2. In this case, during a period (reverse recovery process) required until the depletion layer of the diode 24a2 reduced at a time of application of the forward bias is sufficiently enlarged again, a current in a reverse bias direction (recovery current) passes through the diode 24a2. As indicated by the arrows in the figure, the recovery current R1 is caused to flow so that the collector bus bar 21, the diode 24a2, the IGBT 24b1, and the emitter bus bar 22 are short-circuited (that is, to flow through loop-like path R1 illustrated in FIG. 3).

When the recovery current is thus caused to flow, an eddy current E1 in a reverse direction to the recovery current occurs in both the metal plates 31 and 32 due to an electromagnetic induction effect. A direction of a magnetic flux created by the eddy current E1 is a reverse direction to a direction of a magnetic flux created by the recovery current flowing through the path R1. Therefore, the magnetic flux ascribable to the recovery current is canceled by the magnetic flux ascribable to the eddy current E1. In addition, the eddy current E1 occurs on both sides of the path R1 so as to sandwich the path R1, and hence the magnetic flux ascribable to the recovery current is canceled more positively than in a case where the eddy current E1 occurs only on one side of the path R1. As a result, apparent parasitic inductance in the path R1 is reduced by a reduced amount of a surge voltage that occurs in the path R1.

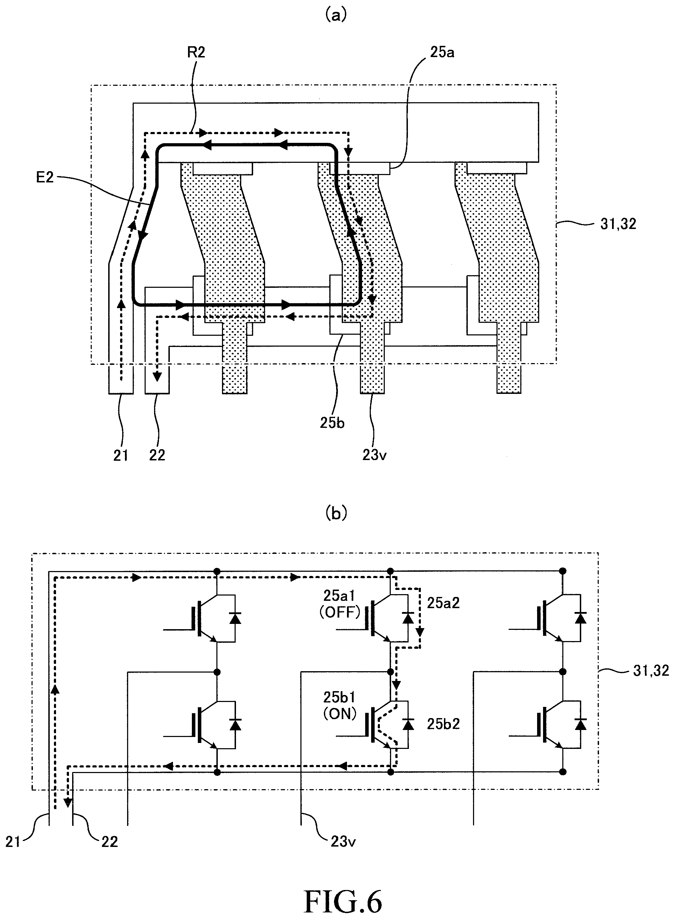

In the same manner, when the recovery current is caused to flow through the other loop-like paths R2 and R3 illustrated in FIG. 3, apparent parasitic inductance in the paths R2 and R3 are reduced. Specifically, as illustrated in a schematic diagram of FIG. 6(a) and a circuit diagram of FIG. 6(b), when a recovery current is caused to flow so that the collector bus bar 21, a diode 25a2, an IGBT 25b1, and the emitter bus bar 22 are short-circuited (that is, to flow through loop-like path R2), an eddy current E2 in a reverse direction to the recovery current occurs in the metal plates 31 and 32. The magnetic flux ascribable to the recovery current is canceled by the magnetic flux ascribable to the eddy current E2, and the apparent parasitic inductance in the path R2 is reduced.

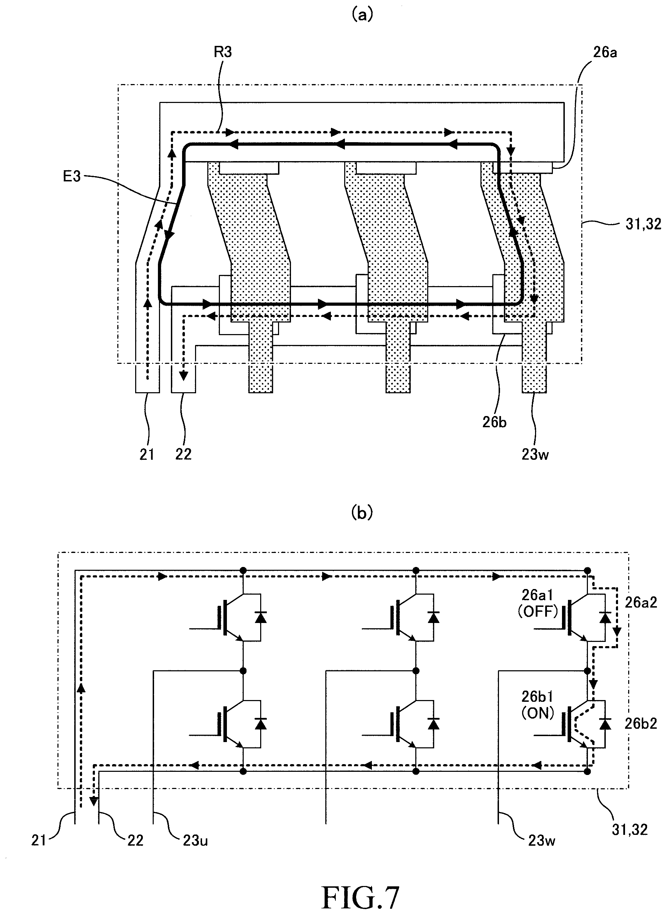

In addition, as illustrated in a schematic diagram of FIG. 7(a) and a circuit diagram of FIG. 7(b), when a recovery current is caused to flow so that the collector bus bar 21, a diode 26a2, an IGBT 26b1, and the emitter bus bar 22 are short-circuited (that is, to flow through loop-like path R3), an eddy current E3 in a reverse direction to the recovery current occurs in the metal plates 31 and 32. The magnetic flux ascribable to the recovery current is canceled by the magnetic flux ascribable to the eddy current E3, and the apparent parasitic inductance in the path R3 is reduced.

In this manner, the embodiment module 10 can reduce the apparent parasitic inductance for each the three loop-like paths R1, R2, and R3 existing for the respective element pairs (that is, for the entire inverter circuit 20). In other words, when the entire power module 10 including the inverter circuit 20 and the metal plates 31 and 32 is assumed to be one system, the parasitic inductance of the system can be reduced. That is, the embodiment module 10 has a configuration capable of reducing the parasitic inductance.

Further, in the embodiment module 10, the metal plates 31 and 32 have a heat dissipation function, and hence the power module can be reduced in size to a lower level than in a case of providing a heat dissipation plate separately from the metal plates 31 and 32. In addition, heat emitted by the semiconductor elements 24a, 25a, and 26a coupled to the collector bus bar 21 is released from the metal plates 31 and 32 via the collector bus bar 21 and the output bus bars 23u, 23v, and 23w, while heat emitted by the semiconductor element 24b, 25b, and 26b coupled to the emitter bus bar 22 is also released from the metal plates 31 and 32 via the emitter bus bar 22 and the output bus bars 23u, 23v, and 23w. Therefore, the heat emitted by the respective semiconductor elements can be released evenly through the use of both the two metal plates 31 and 32, and hence the heat dissipation function of the metal plates 31 and 32 can be used to the maximum, which can increase heat dissipation performance of the power module.

### <Other Embodiments>

The present invention is not limited to the above-mentioned embodiment, and can employ various modification examples within the scope of the present invention. For example, the metal plates 31 and 32 employed for the embodiment module 10 are each a single plate body that does not have a notch, an opening portion, or the like. However, the metal plates 31 and 32 do not necessarily sandwich the entire inverter circuit 20 completely, and may have such shapes as to sandwich only parts of the inverter circuit 20 that correspond to the paths R1, R2, and R3. That is, parts of the metal plates 31 and 32 that do not correspond to the path R1, R2, or R3 may be provided with a notch, an opening portion, or the like. Further, each of the metal plates 31 and 32 is not necessarily a single plate body, and may be a plate body obtained by joining a plurality of metal plates so as to allow the conduction. Further, the metal plates 31 and 32 may be a combination of a plurality of plate bodies that are separated for the respective paths R1, R2, and R3 so as to inhibit the conduction.

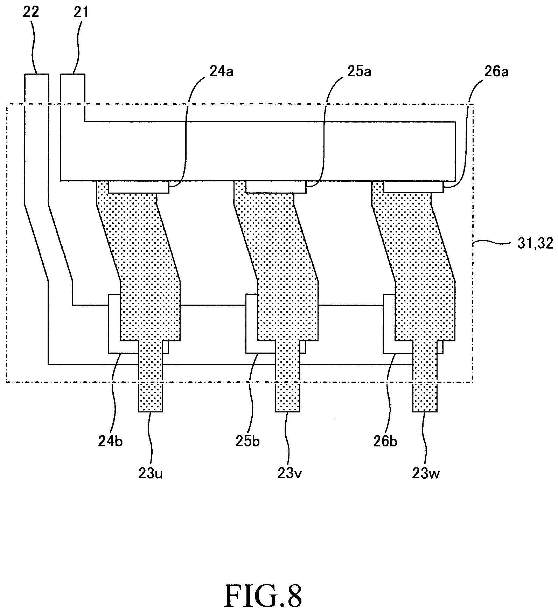

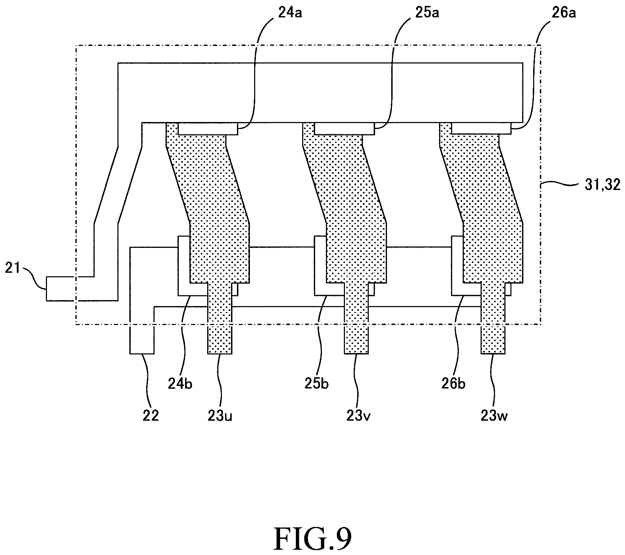

Further, the embodiment module 10 includes the collector bus bar 21, and the emitter bus bar 22, and the output bus bars 23u, 23v, and 23w extending from the embodiment module 10 toward the same direction. However, the respective bus bars do not necessarily extend in the same direction. For example, as illustrated in FIG. 8, the direction in which the collector bus bar 21 and the emitter bus bar 22 extend and the direction in which the output bus bars 23u, 23v, and 23w extend may be reverse to each other. Further, as illustrated in FIG. 9, the collector bus bar 21 and the emitter bus bar 22 may extend in different directions.

That is, an arrangement of the respective bus bars may be determined to be any arrangement as long as the respective paths (R1, R2, and R3 illustrated in FIG. 3) through which the recovery current is caused to flow are curved around the inside of the region sandwiched between the metal plates 31 and 32 along side surfaces of the above-mentioned region substantially by one round. For example, when the metal plates 31 and 32 each have a shape of a rectangle in plan view as in the embodiment module 10, the respective paths only need to be formed of four paths substantially parallel with the respective four sides of the rectangle (corresponding to the side surfaces of the region described above).

## Claims

1. A power module, comprising:
an inverter circuit;
a pair of conductors that sandwich the inverter circuit, wherein:
the inverter circuit comprises:
a positive bus bar, a negative bus bar, and a plurality of output bus bars that extend from an outside of a region sandwiched between the pair of conductors to an inside of the region; and
a plurality of element pairs provided inside the region,
the plurality of element pairs each having such a configuration that a semiconductor element coupled to the positive bus bar and a semiconductor element coupled to the negative bus bar are coupled to each other via each of the plurality of output bus bars,
the semiconductor elements each comprising a switching element and a diode connected in antiparallel with the switching element; and
the positive bus bar, the plurality of element pairs, and the negative bus bar define conductive paths each exhibiting a loop-like shape facing the pair of conductors inside the region.

2. A power module according to claim 1, wherein:
the pair of conductors have flat plate-like shapes parallel with each other; and
the conductive paths exist on the same virtual plane that is parallel with the pair of conductors.

3. A power module according to claim 1 or 2, wherein the positive bus bar and the negative bus bar are spaced apart from each other by a minimum distance that enables insulation in a boundary plane between the outside and the inside of the region.

4. A power module according to any one of claims 1 to 3, wherein:
the pair of conductors comprise a first metal plate and a second metal plate that are configured to release heat emitted by the plurality of element pairs toward the outside of the region;
the plurality of output bus bars each comprise a first end portion coupled to the semiconductor element coupled to the positive bus bar and a second end portion coupled to the semiconductor element coupled to the negative bus bar; and
inside the region:
the positive bus bar and the first metal plate are adjacent to each other while being insulated from each other;
the negative bus bar and the second metal plate are adjacent to each other while being insulated from each other;
the first end portion and the second metal plate are adjacent to each other while being insulated from each other;
the second end portion and the first metal plate are adjacent to each other while being insulated from each other;
the semiconductor element coupled to the positive bus bar is sandwiched between the positive bus bar and the first end portion; and
the semiconductor element coupled to the negative bus bar is sandwiched between the negative bus bar and the second end portion.
